# EUROPEAN PATENT APPLICATION

(11) **EP 4 672 886 A1**
(43) Date of publication of application: **31.12.2025**
(21) Application number: 25155471.3
(22) Date of filing: 03.02.2025
(51) Int. Cl.: H05K 7/20

(54) **LIQUID COOLING SYSTEM**

(30) Priority: 26.06.2024 US 202418754388
(71) Applicant: Purple Cloud Development Pte. Ltd., Singapore 128424 (SG)
(72) Inventor: SHIH, HONG-YI, 114065 Taipei City (TW); LIN, KENG-HAN, 114065 Taipei City (TW); LIEN, KUO-CHEN, 114065 Taipei City (TW)
(74) Representative: Grünecker Patent- und Rechtsanwälte PartG mbB

(57) **Abstract**

A liquid cooling system including a direct liquid cooling loop, system board, and cooling distribution unit is provided. The direct cooling loop includes a flexible tubing section, proximal fitting, distal fitting, and cold plate. A proximal connection end of the flexible tubing section is coupled to a proximal fitting attachment end of the proximal fitting via a proximal lap joint. A distal connection end of the flexible tubing section is coupled to a distal fitting attachment end of the distal fitting via a distal lap joint. The flexible tubing section is fluidly in communication with at least one of an inlet and outlet of the cold plate. A first integrated circuit components of the system board is physically and thermally coupled to the at least one direct liquid cooling loop via the cold plate. The cooling distribution unit is fluidly in communication with the at least one direct liquid cooling loop, providing a working fluid thereto.

## Description

### TECHNICAL FIELD

The present disclosure is related to thermal management of electronic systems in general and more particularly but not limited to liquid cooling systems.

### BACKGROUND OF THE INVENTION

Liquid cooling systems are used in electronic systems in industries such as computing, data center, electric vehicle (EV) fast charging, telecom, laser, and medical equipment for thermal management. In data centers, in addition to air cooling, two types of liquid cooling techniques are used for servers, cold plate cooling (or direct-to-chip cooling (DTC) or direct liquid cooling (DLC)) and immersion cooling.

Cold plate cooling involves mounting of a cold plate directly on top of heat sources such as CPUs and GPUs. A working fluid inside of a cold plate chamber absorbs and transfers heat away from the integrated circuit components. Immersion cooling submerges the integrated circuit components in a dielectric immersion fluid, allowing for heat dissipation into the immersion fluid via direct contact.

Fundamental components of liquid cooling systems are cooling lines (or tubing or piping) as leakage of working fluid may cause servers to malfunction, fail and cause data center downtime. Increasing working fluid pressure and flow rate requirements due to increasing heat generation from faster and faster integrated circuit components exacerbate risks.

To meet increasing heat dissipation requirements, larger and heavier duty cooling lines, such as rigid copper tubing or reinforced rubber tubing may be used. However, with servers arranged in a server rack at close proximity, the larger cooling lines may obstruct airflow, decreasing heat dissipation efficiency of the server rack. In addition, heavier and bulkier fittings and connectors may further block airflow and hinder access and maintenance of the servers. Proprietary servers are costly, and rigid cooling lines make upgrading components and rerouting of cooling lines extremely difficult.

### SUMMARY OF THE INVENTION

The present disclosure provides an efficient and scalable liquid cooling system according to claim 1. The at least one flexible tubing section is preferably made of stainless steel. Footprints of cooling lines are decreased via the preferred stronger and lighter stainless steel and the lap joint fittings and connections of the at least one flexible tubing section. A multitude of variations of rigid with flexible cooling lines can be available, making upgrading of components and rerouting of cooling lines easier and more feasible.

The liquid cooling system includes at least one direct liquid cooling loop, at least one system board, and a cooling distribution unit. The at least one direct liquid cooling loop includes at least one flexible tubing section, at least one proximal fitting, and at least one distal fitting. A proximal connection end of the at least one flexible tubing section is coupled to a proximal fitting attachment end of the at least one proximal fitting via a proximal lap joint. A distal connection end of the at least one flexible tubing section is coupled to a distal fitting attachment end of the at least one distal fitting via a distal lap joint. At least one first integrated circuit component of the at least one system board is physically and thermally coupled to the at least one direct liquid cooling loop. Preferably, at least one second integrated circuit component of the at least one system board is physically and thermally not coupled to the at least one direct liquid cooling loop. The cooling distribution unit is fluidly in communication with the at least one direct liquid cooling loop, providing a working fluid thereto.

In at least one embodiment, the liquid cooling system further includes a supply manifold and a return manifold. The cooling distribution unit is fluidly coupled to the supply manifold and the return manifold and the supply manifold is further fluidly connected to the at least one direct liquid cooling loop and the return manifold is further fluidly connected to the at least one direct liquid cooling loop.

In at least one embodiment, the at least one flexible tubing section is made of corrugated stainless steel. In at least one embodiment, an outer diameter of the at least one flexible tubing section is between 12 to 16 millimeters, inclusive. In at least one embodiment, a thickness of the at least one flexible tubing section is 0.5 millimeters.

In at least one embodiment, the at least one direct liquid cooling loop further includes at least one cold plate, whereby the at least one first integrated circuit component is thermally coupled to the at least one cold plate. In at least one embodiment, the at least one cold plate includes two of the at least one cold plate and the at least one first integrated circuit component includes two of the at least one first integrated circuit component, whereby the second of the at least one first integrated circuit component is thermally coupled to the second of the at least one cold plate. In at least one embodiment, the at least one cold plate includes an inlet and an outlet, whereby the at least one flexible tubing section is fluidly in communication with at least one of the inlet and the outlet. In at least one embodiment, the at least one flexible tubing section includes two of the at least one flexible tubing section. The at least one flexible tubing section is fluidly in communication with the outlet and a second of the at least one flexible tubing section is fluidly in communication with the inlet. In at least one embodiment, the at least one flexible tubing section includes three at least one flexible tubing sections, whereby the at least one flexible tubing section is fluidly in communication with the outlet of the at least one cold plate, a second of the at least one flexible tubing section is fluidly in communication with an inlet of the second of the at least one cold plate, and a third of the at least one flexible tubing section is fluidly in communication with the inlet of the at least one cold plate and an outlet of the second of the at least one cold plate.

In at least one embodiment, the at least one proximal fitting includes at least one of a straight rigid tubing section, a bent rigid tubing section, a barb fitting, a fluid connector, a sleeve, a push in adapter, an angled adapter fitting, and a spacer fitting. In at least one embodiment, the at least one distal fitting includes at least one of a straight rigid tubing section, a bent rigid tubing section, a barb fitting, a fluid connector, a sleeve, a push in adapter, an angled adapter fitting, and a spacer fitting.

In at least one embodiment, the proximal lap joint is defined by at least one of a proximal fitting socket of the proximal fitting attachment end, whereby the proximal fitting socket overlaps the proximal connection end, and a proximal connection socket of the proximal connection end, whereby the proximal connection socket overlaps the proximal fitting attachment end. In at least one embodiment, a proximal fitting socket depth of the proximal fitting socket is between 3 to 5 millimeters, inclusive, and a proximal connection socket depth of the proximal connection socket is between 3 to 5 millimeters, inclusive. In at least one embodiment, a thickness of the proximal fitting socket is 5 millimeters and a thickness of the proximal connection socket is 5 millimeters.

In at least one embodiment, the distal lap joint is defined by at least one of a distal fitting socket of the distal fitting attachment end, whereby the distal fitting socket overlaps the distal connection end, and a distal connection socket of the distal connection end, whereby the distal connection socket overlaps the distal fitting attachment end. In at least one embodiment, a distal fitting socket depth of the distal fitting socket is between 3 to 5 millimeters, inclusive, and a distal connection socket depth of the distal connection socket is between 3 to 5 millimeters, inclusive. In at least one embodiment, a thickness of the distal fitting socket is 5 millimeters and a thickness of the distal connection socket is 5 millimeters.

In at least one embodiment, the liquid cooling system further includes a proximal filler metal and a distal filler metal. The proximal filler metal defines a proximal capillary space of the proximal lap joint between the proximal connection end and the proximal fitting attachment end. The distal filler metal defines a distal capillary space of the distal lap joint between the distal connection end and the distal fitting attachment end.

### BRIEF DESCRIPTION OF DRAWINGS

Unless specified otherwise, the accompanying drawings illustrate aspects of the innovative subject matter described herein. Referring to the drawings, wherein like reference numerals indicate similar parts throughout the several views, several examples of liquid cooling systems, cooling loops, and flexible tubes incorporating aspects of the presently disclosed principles are illustrated by way of example, and not by way of limitation.
Fig. 1 illustrates a liquid cooling system according to one embodiment of the present disclosure.
Fig. 2 is a perspective view of a direct cooling loop according to one embodiment of the present disclosure.
Fig. 3A is a perspective view of a flexible tubing section according to one embodiment of the present disclosure.
Fig. 3B is a cross-section along line A-A of the flexible tubing section of Fig. 3A according to one embodiment of the present disclosure.
Fig. 3C is a cross-section along line B-B of the flexible tubing section of Fig. 3A according to one embodiment of the present disclosure.
Fig. 4 is a perspective view of cold plates according to one embodiment of the present disclosure.
Fig. 5 is an exploded view of a direct cooling line according to one embodiment of the present disclosure.
Fig. 6 is a perspective view of another direct cooling loop according to one embodiment of the present disclosure.
Fig. 7 is a perspective view of yet another direct cooling loop according to one embodiment of the present disclosure.

### DETAILED DESCRIPTION

The following describes various principles related to liquid cooling systems by way of reference to specific examples of direct liquid cooling loops, including specific arrangements and examples of cooling lines embodying innovative concepts. More particularly, but not exclusively, such innovative principles are described in relation to selected examples of flexible tubing sections and coupling methods of the flexible tubing sections via fitting and connector assemblages, and well-known functions or constructions are not described in detail for purposes of succinctness and clarity. Nonetheless, of the disclosed principles can be incorporated in various other embodiments of different flexible tubing sections and coupling methods of the flexible tubing sections via fitting and connector assemblages to achieve any of a variety of desired outcomes, characteristics, and/or performance criteria.

Thus, liquid cooling systems having attributes that are different from those specific examples discussed herein can embody of the innovative principles, and can be used in applications not described herein in detail. Accordingly, embodiments of liquid cooling systems not described herein in detail also fall within the scope of this disclosure, as will be appreciated by those of ordinary skill in the relevant art following a review of this disclosure.

Example embodiments as disclosed herein are directed to heat dissipation of packaged and unpackaged integrated circuit components of servers in a data center. A packaged integrated circuit component can comprise one or more integrated circuits mounted on a package substrate. An unpackaged integrated circuit component can comprise one integrated circuit die directly attached to a printed circuit board. Integrated circuit components can comprise a system-on-a-chip (SoC), a central processing unit (CPU), a graphics processing unit (GPU), an accelerator, an I/O controller, a chipset processor, a memory, and a network interface controller. Liquid cold plates allow circulation of a working fluid inside a metal plate. The working fluid is usually a mix of water and glycol, but fluids such as oil and dielectric oil can also be used. A liquid cooling plate can comprise friction stir welded (FSW) aluminum liquid cold plates, vacuum brazed aluminum or stainless steel liquid cold plates, embedded copper, aluminum or stainless steel tube aluminum liquid cold plates, copper brazed liquid cold plates, and gun-drilled or deep drilled liquid cold plates. A liquid cooling loop can comprise liquid cold plates, cooling lines (tubing and piping), manifolds, fans, pump(s), expansion tank(s), and a cooling distribution unit.

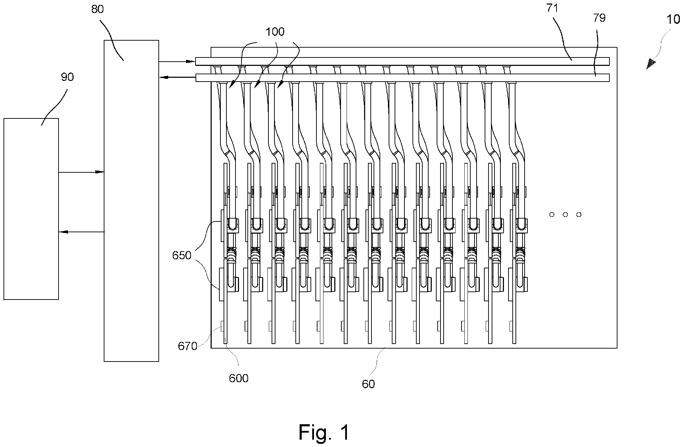

Figs. 1 is an exemplary embodiment of a liquid cooling system 10. The liquid cooling system 10 includes at least one direct liquid cooling loop 100, at least one system board 600, and a cooling distribution unit 80.

The liquid cooling system 10 further includes a supply manifold 71 and a return manifold 79. The cooling distribution unit 80 (or CDU) is fluidly coupled to the supply manifold 71 and the return manifold 79. The supply manifold 71 and the return manifold 79 is fluidly connected to the at least one direct liquid cooling loop 100. The CDU 80 provides working fluid to the supply manifold 71 via a pump (not shown). The working fluid passes through the at least one direct liquid cooling loop 100, absorbing heat generated by the at least one first integrated circuit component 650. Heated working fluid exits the at least one direct liquid cooling loop 100 and enters the return manifold 79. The CDU 80 receives the heated working fluid from the return manifold 79, cools the working fluid, and returns the working fluid to the supply manifold 71. The working fluid can be a single-phase or two-phase working fluid. The cooling distribution unit 80 is fluidly in communication with the at least one direct liquid cooling loop 100, providing a working fluid (not shown) thereto.

The liquid cooling system 10 further includes a facility (or building) water source 90. The facility water source 90 is fluidly connected to the CDU 80. In at least one embodiment, the at least one system board 600 is more than one at least one system board 600, mounted in a system board (or server) rack 60 via fasteners and brackets.

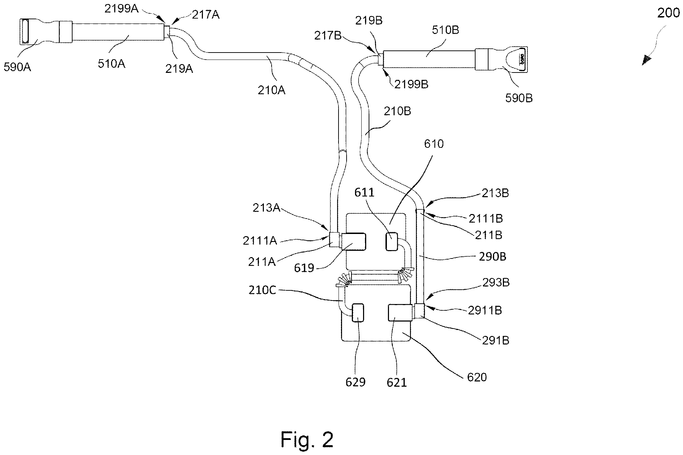

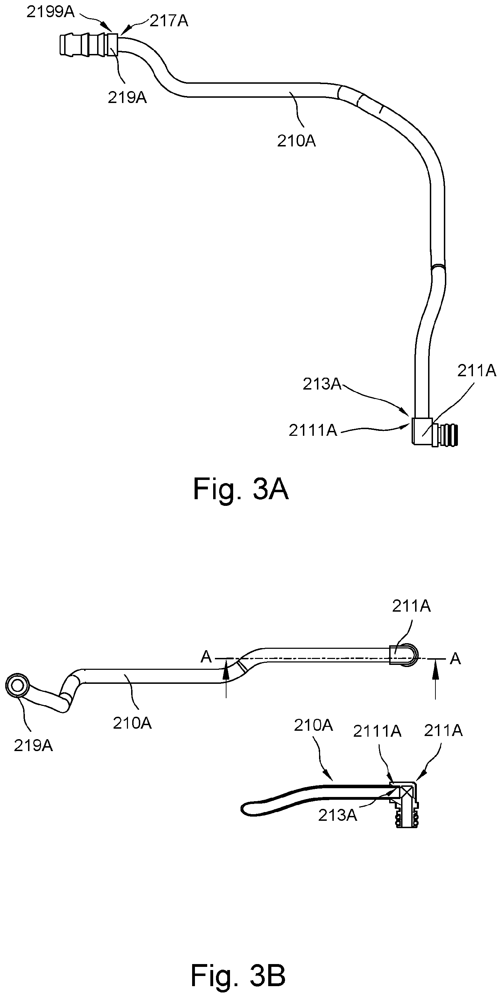

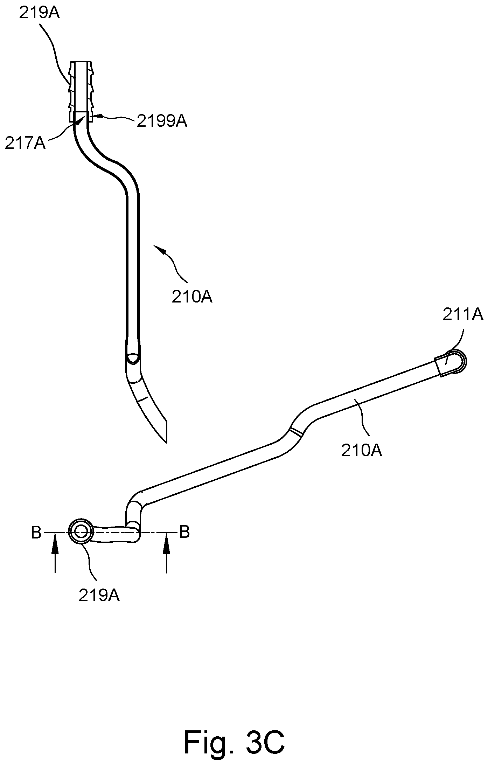

Alternatively or additionally, in the cooling system 10 of Fig. 1 the embodiment of the direct liquid cooling loop 200 shown in Fig. 2 can be used. As can be also seen from Fig. 3A to 3C, the direct liquid cooling loop 200 includes a first flexible tubing section 210A, a proximal fitting 211A, and a distal fitting 219A. A proximal connection end 213A of the first tubing section 210A is coupled to a proximal fitting attachment end 2111A of the proximal fitting 211A via a proximal lap joint. A distal connection end 217A of the first tubing section 210A is coupled to a distal fitting attachment end 2199A of the distal fitting 219A via a distal lap joint. A first integrated circuit component 650 of the system board 600 is physically and thermally coupled to the at least one direct liquid cooling loop 100, 200. A second integrated circuit component 670 of the system board 600 is physically and thermally not coupled to the at least one direct liquid cooling loop 100, 200.

The at least one first integrated circuit component 650 is thermally coupled to a first cold plate 610 and/or a second cold plate 620 of the at least one direct liquid cooling loop 100, 200. In at least one embodiment, the at least one first integrated circuit component 650 is thermally coupled to the first cold plate 610 and/or the second cold 620 via a thermal interface material (TIM) layer (not shown) disposed between the at least one first integrated circuit component 650 and the first cold plate 610 and/or the second cold plate 620. In at least one embodiment, the first cold plate 610 and/or the second cold plate 620 can further include a thermally conductive base. The first integrated circuit component 650 is thermally coupled to the thermally conductive base of the first cold plate 610 and/or the second cold plate 620. A TIM layer can be any suitable material, such as a silver thermal compound, thermal grease, phase change materials, indium foils, or graphite sheets. A first cold plate 610 or second cold plate 620 can be any suitable type of cold plate, such as a tubed cold plate or a cold plate comprising internal fins or channels (e.g., microchannels) and be made of any suitable material, such as copper, aluminum, or stainless steel, that is chemically compatible with working fluids. The first cold plate 610 includes an inlet 611 and an outlet 619. The first flexible tubing section 210A is fluidly in communication with the outlet 619.

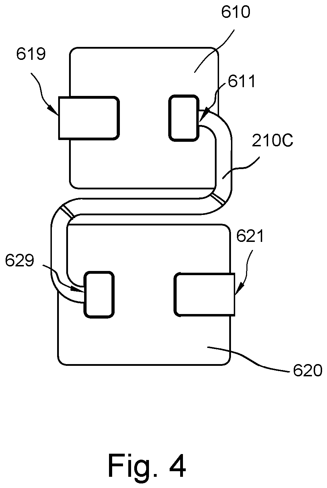

Fig. 4 shows a further embodiment of cold plates 610, 620 of the at least one direct liquid cooling loop 100, 200. The at least one cold plate 610, 620 of the at least one direct liquid cooling loop 100, 200 may be similar in some respects to the at least one cold plate 610, 620 of the at least one direct liquid cooling loop 100, 200 of Figs. 1-2, and therefore may be best understood with reference thereto where like numerals designate like components not described again in detail.

The at least one direct liquid cooling loop 100, 200 can include more than one of the at least one flexible tubing section that form the at least one direct liquid cooling loop 100, 200 from the supply manifold 71 to the return manifold 79. In at least one embodiment, the at least one flexible tubing section includes a first and a second flexible tubing section 210A, 210B. The first flexible tubing section 210A is fluidly in communication with the outlet 619 and a second flexible tubing section 210B is fluidly in communication with an inlet 621.

The at least one direct liquid cooling loop 100, 200 can include more than one of the at least one cold plate that form the at least one direct liquid cooling loop 100, 200 from the supply manifold 71 to the return manifold 79. In at least one embodiment, the at least one cold plate includes a first and a second cold plate 610 and 620 and the at least one first integrated circuit component includes a first and a second first integrated circuit component 650. The first first integrated circuit component 650 is thermally coupled to the first cold plate 610 and the second first integrated circuit component 650 is thermally coupled to the second cold plate 620.

In the embodiment shown in Fig. 2, the at least one flexible tubing section includes a first, a second and a third flexible tubing section 210A, 210B, 210C. The first flexible tubing section 210A is fluidly in communication with the outlet 619 of the first cold plate 610 and a second flexible tubing section 210B is fluidly in communication with an inlet 621 of the second cold plate 620. In at least one embodiment, the second cold plate 620 is arranged in series configuration and a third flexible tubing section 210C is fluidly in communication with the inlet 611 of the first cold plate 610 and an outlet 629 of the second cold plate 620. A proximal connection end 213A of the first tubing section 210A is coupled to a proximal fitting attachment end 2111A of the proximal fitting 211A via a proximal lap joint. A proximal connection end 213B of the second tubing section 210A is coupled to a proximal fitting attachment end 2111B of the proximal fitting 211B via a proximal lap joint. A proximal lap joint is defined by a proximal fitting socket of a first proximal fitting attachment end 2111A and a second proximal fitting attachment end 2111B, whereby the proximal fitting socket overlaps a first proximal connection end 213A of the first flexible tubing section 210A and a second proximal connection end 213B of the second flexible tubing section 210B. The proximal fitting 211A is coupled to the outlet 619 of the first cold plate 610. The proximal fitting 211B is formed by a distal end of a straight tubing section 290B. The proximal connection end 293B of the straight tubing section 290B is coupled to a proximal fitting attachment end 2911B of a fluid connector 291B. The fluid connector 291B is coupled to the inlet 621 of the second cold plate 620.

The at least one direct liquid cooling loop 100, 200 is formed from the supply manifold 71 to the return manifold 79 by routing a working fluid to the at least one system board 600 comprising the first first integrated circuit component 650 and the second first integrated circuit component 650. The working fluid can include a subcooled single-phase liquid coolant having a predetermined pressure and predetermined temperature at an inlet 621 of the second cold plate 620. The predetermined temperature can be below a saturation temperature of the subcooled single-phase liquid coolant at the predetermined pressure. The working fluid flows through a second of the thermally conductive base member of the second cold plate 620, absorbing a first amount of heat generated by the second first integrated circuit component 650. The working fluid having the absorbed first amount of heat exits the second cold plate 620 at the outlet 629 of the second cold plate 620 and is transported via the third flexible tubing section 210C to the inlet 611 of the first cold plate 610. Despite absorbing the first amount of heat, the working fluid is still below the saturation temperature of the subcooled single-phase liquid coolant at a predetermined pressure at the inlet 611 of the first cold plate 610. The working flows through the thermally conductive base member of the first cold plate 610, absorbing a second amount of heat generated by the at least one first integrated circuit component 650. The heated working fluid exits the first cold plate 610 at the outlet 619 of the first cold plate 610 and follows a return path to the return manifold 79. The CDU 80 receives the heated working fluid from the return manifold 79, cools the working fluid, and returns the working fluid to the supply manifold 71. The working fluid can be a single-phase or two-phase working fluid. The embodiment shown in Fig. 4 can be completed as described above.

In at least one embodiment, the at least one flexible tubing section 210A, 210B, 210C is made of corrugated stainless steel. The at least one flexible tubing section 210A, 210B, 210C can include a corrugated stainless steel tubing (CSST) that can be brazed to fittings and connectors on ends thereof. A CCST can include 304L and 316L stainless steel, as examples. A CSST is a flexible, kink-less, light weight, pressure resistant, fatigue resistant, temperature resistant, and corrosion resistant, stainless steel cylindrical tubing (or cooling line or hosing or piping) with a corrugated surface area structure. The CSST tubing can be braided or non-braided stainless steel. A braided CSST can include flat wire braids or strip braids and a non-braided CSST can include a helical annular corrugated profile, U-shaped annular corrugated profile, or an omega-shaped annular corrugated profile, as examples. In at least one embodiment, an outer diameter of the at least one flexible tubing section 210A, 210B, 210C is between 12 to 16 millimeters, inclusive. In at least one embodiment, a thickness of the at least one flexible tubing section 210A, 210B, 210C is 0.5 millimeters.

In at least one embodiment, the at least one proximal fitting 211A, 211B includes at least one of a straight rigid tubing section, a bent rigid tubing section, a barb fitting, a fluid connector, a sleeve, a push in adapter, an angled adapter fitting, and a spacer fitting. In at least one embodiment, the at least one distal fitting 219A, 219B includes at least one of a straight rigid tubing section, a bent rigid tubing section, a barb fitting, a fluid connector, a sleeve, a push in adapter, an angled adapter fitting, and a spacer fitting.

In at least one embodiment, a direct cooling loop 100, 200 includes one of the at least one flexible tubing section 210A. The at least one direct liquid cooling loop 100, 200 can further include more than one of the at least one flexible tubing section 210A, 210B, 210C. In at least one embodiment, the at least one direct liquid cooling loop 100, 200 includes the at least one flexible tubing section 210B and a straight rigid tubing section 211B. The at least one direct liquid cooling loop 100, 200 can further include one or more than one of the at least one flexible tubing section 210A, 210B, straight rigid tubing section 211B, and bent rigid tubing section, or any combination of the foregoing. As an example, a bent rigid tubing section having a fluid connector on one end, can be coupled to the second of the at least one cold plate 620 on one end and coupled to the at least one flexible tubing section on an other end. A second of the bent rigid tubing section having a second fluid connector on one end, can be coupled to the at least one cold plate 610 on one end and coupled to the at least one flexible tubing section on an available end. The bent rigid tubing section and the second of the bent rigid tubing section can assure curved flow of working fluid exiting and entering the second of the at least one cold plate 620 and the at least one cold plate 610. The at least one flexible tubing section 210A, 210B, 210C can allow adjustments to the size or disposition of the at least one cold plate 610 and the second of the at least one cold plate 620. A multitude of variations of rigid with flexible cooling loops can be available, making upgrading of components and rerouting of cooling lines easier and more feasible.

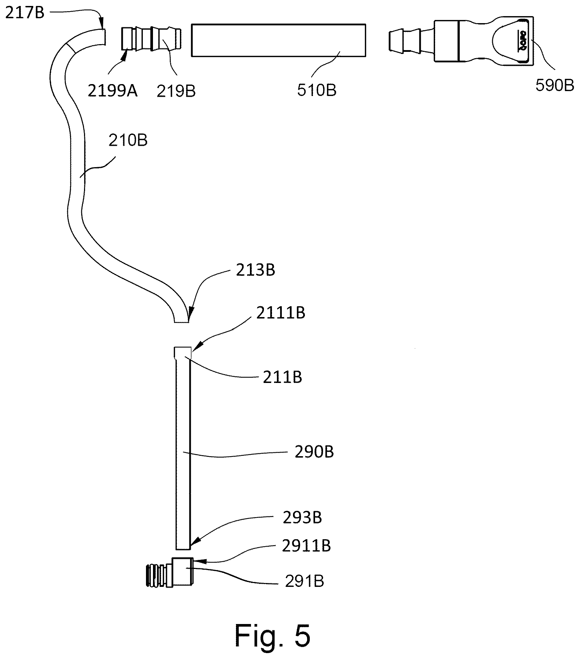

Fig. 5 shows a direct cooling line of the at least one direct liquid cooling loop 100, 200 similar to the one shown in FIG. 2 on the right side. The at least one direct liquid cooling loop 100, 200 includes a straight rigid tubing section 290B having a fluid connector 291B on one end to be coupled to the inlet 621 of the second cold plate 620 on one end and to be coupled to the second flexible tubing section 210B on an other end. The available end of the at least one flexible tubing section 210B is coupled to a second barbed fitting 219B and the second barbed fitting 219B is coupled to a rubber tubing 510B. A quick disconnect fitting 500B is coupled to the rubber tubing 510B for connection to the supply manifold 71.

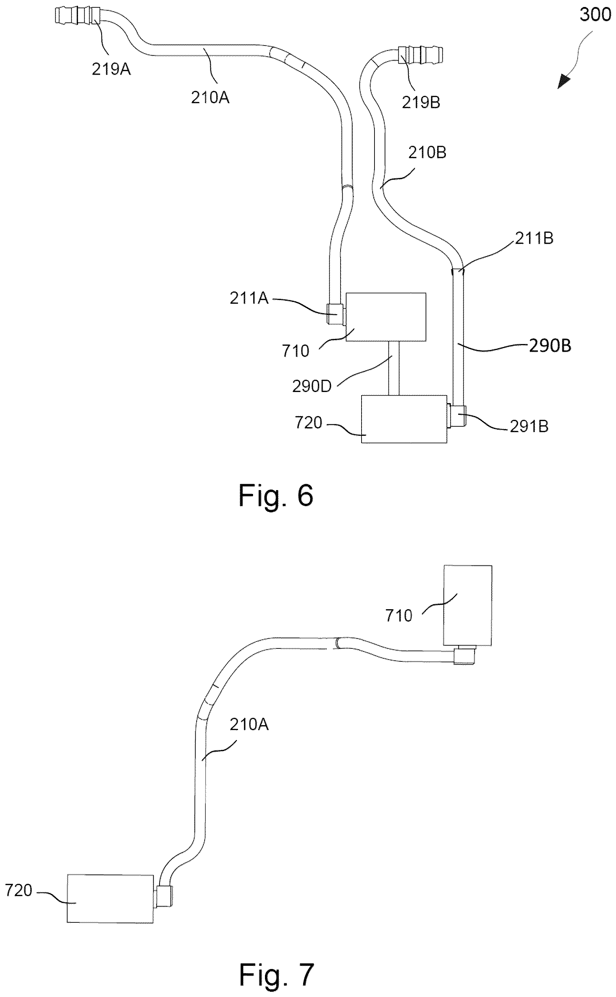

Fig. 6 includes at least one embodiment of another direct cooling loop 300. The another direct cooling loop 300 may be similar in some respects to the at least one direct liquid cooling loop 100, 200 of Figs. 1-2, and therefore may be best understood with reference thereto where like numerals designate like components not described again in detail. The at least one direct liquid cooling loop 300 can include at least one flexible tubing section (preferably a first flexible tubing section 210A), a straight rigid tubing section 290B, at least one proximal fitting 211A, 211B, at least one distal fitting 219A, 219B, and at least one water flow-through chamber (preferably a first water flow-through chamber 710). In the shown embodiment, the at least one flexible tubing section includes a first and a second flexible tubing section 210A and 210B and the at least one water flow-through chamber includes a first and a second water flow-through chamber 710, 720. A working fluid is transported through a second of the at least one flexible tubing section 210B and through a first straight rigid tubing section 212B and enters a second water flow-through chamber 720 at an input of the second water flow-through chamber 720. The working fluid flows through the second water flow-through chamber 720 and exits the second water flow-through chamber 720 at an outlet of the second water flow-through chamber 720. The working fluid is transported through a second rigid tubing section 290D to an inlet of the first water flow-through chamber 710. The working fluid flows through the first water flow-through chamber 710 exiting the first water flow-through chamber 710 at an outlet of the first water flow-through chamber 710. The flow of the working fluid is a continuous cycle.

Fig. 7 is a perspective view of a part of a yet another direct cooling loop. The yet another direct cooling loop may be similar in some respects to the another direct cooling loop 300 of Fig. 6, and therefore may be best understood with reference thereto where like numerals designate like components not described again in detail. The first and the second water flow-through chamber 710 and 720 can be connected via the first flexible tubing section 210A.

In at least one embodiment, the proximal lap joint is defined by at least one of a proximal fitting socket of the proximal fitting attachment end 2111A, 2111B, whereby the proximal fitting socket overlaps the proximal connection end 213A, 213B (as in Fig. 2), and a proximal connection socket of a proximal connection end, and a proximal connection socket of a proximal connection end, whereby the proximal connection socket overlaps the proximal fitting attachment end. In at least one embodiment, a proximal fitting socket depth of the proximal fitting socket is between 3 to 5 millimeters, inclusive, and a proximal connection socket depth of the proximal connection socket is between 3 to 5 millimeters, inclusive. In at least one embodiment, a thickness of the proximal fitting socket is 5 millimeters and a thickness of the proximal connection socket is 5 millimeters.

In at least one embodiment, the distal lap joint is defined by at least one of a distal fitting socket of the distal fitting attachment end 2199A, 2199B whereby the distal fitting socket overlaps the distal connection end 217A, 217B (as in Fig. 2), and a distal connection socket of a distal connection end, whereby the distal connection socket overlaps the distal fitting attachment end. In at least one embodiment, a distal fitting socket depth of the distal fitting socket is between 3 to 5 millimeters, inclusive, and a distal connection socket depth of the distal connection socket is between 3 to 5 millimeters, inclusive. In at least one embodiment, a thickness of the distal fitting socket is 5 millimeters and a thickness of the distal connection socket is 5 millimeters.

In at least one embodiment, the liquid cooling system 10 further includes a proximal filler metal (not shown) and a distal filler metal (not shown). The proximal filler metal defines a proximal capillary space of the proximal lap joint between the proximal connection end 213A, 213B and the proximal fitting attachment end 2111A, 2111B. The distal filler metal defines a distal capillary space of the distal lap joint between the distal connection end 217A, 217B and the distal fitting attachment end 2199A, 2199B. A filler metal can include a metal alloy that has a melting temperature below that of the at least one flexible tubing section 210A, 210B, 210C, the at least one proximal fitting 211A, 211B and/or the at least one distal fitting 219A, 219B.

In at least one embodiment, the proximal lap joint is a butt joint having a sleeve and/or the distal lap joint is a butt joint having a sleeve. In at least one embodiment, brazing is used for coupling at the proximal lap joint and the distal lap joint. In at least one embodiment, welding is used for coupling at the proximal lap joint and the distal lap joint. Thus, heavier and bulkier fittings and connectors are minimized, such as flange ends, threaded ends, and clamp ends, opening up airflow which would have been blocked by the larger fittings and connectors and allowing easier access and maintenance of the at least one system board 600. The brazed proximal lap joint and distal lap joint resist corrosive media as only a small seam is exposed to the atmosphere. Also, the brazed stainless steel connections are strong in both tensile and shear strength via capillary action occurring between the gap filled by the filler metal.

The liquid cooling system 10 of the embodiments described herein provide an efficient and scalable liquid cooling system 10. The combination of flexible tubing sections 210A, 210B, 210C, straight rigid tubing sections 290B, 290D and bent rigid tubing sections allow for a variety of cooling line designs, making upgrading of components and rerouting of cooling lines easier and more feasible. As an example, cooling lines may be coupled to proprietary cold plates should a size or disposition of the proprietary cold plates need to be replaced or upgraded and/or efficient rerouting or placement of proprietary cooling lines is not possible. The liquid cooling system 10 is suitable for retrofitting of existing server designs or can be incorporated into new server or processor designs. The stainless steel material of the at least one flexible tubing section 210A, 210B, 210C allow the at least one flexible tubing section 210A, 210B, 210C to be flexible, kink-less, light weight, pressure resistant, fatigue resistant, temperature resistant, and corrosion resistant. The brazed lap joint connection of the at least one flexible tubing section 210A, 210B, 210C allow footprint of the cooling lines to decrease versus flange ends, threaded ends, and clamp ends, opening up airflow which would have been blocked by larger fittings and connectors and allowing easier access and maintenance of the at least one system board 600. Also, the lower profile of the at least one system board 600 not having the larger fittings and connectors, allow the at least one system board 600 to be arranged in close proximity to neighboring system boards 600 in the same system board rack 60, thereby allowing more system boards 600 to be installed and cooled per square foot of floor space in data centers. Moreover, the brazed stainless steel connections are strong in both tensile and shear strength via capillary action between the gap filled by the filler metal. Furthermore, the at least one stainless steel flexible tubing section 210A, 210B, 210C can also be brazed with aluminum, in addition to copper plates.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean than one of the element that it introduces.

## Claims

1. A liquid cooling system (10), comprising:
at least one direct liquid cooling loop (100, 200, 300), an individual of the at least one direct liquid cooling loop (100, 200, 300), comprising,
at least one flexible tubing section (210A, 210B, 210C) having a proximal connection end (213A, 213B) and a distal connection end (217A, 217B),
at least one proximal fitting (211A, 211B) having a proximal fitting attachment end (2111A, 2111B), the proximal connection end (213A, 213B) coupled to the proximal fitting attachment end (2111A, 2111B) via a proximal lap joint, and
at least one distal fitting (219A, 219B) having a distal fitting attachment end (2199A, 2199B), the distal connection end (217A, 217B) coupled to the distal fitting attachment end (2199A, 2199B) via a distal lap joint,
at least one system board (600), an individual of the at least one system board (600), comprising,
at least one first integrated circuit component (650) physically and thermally coupled to the at least one direct liquid cooling loop (100, 200, 300), and
a cooling distribution unit (80) fluidly in communication with the at least one direct liquid cooling loop (100, 200, 300), providing a working fluid to the at least one direct liquid cooling loop (100, 200, 300).

2. The liquid cooling system (10) of claim 1, wherein the proximal lap joint is defined by at least one of a proximal fitting socket of the proximal fitting attachment end (2111A, 2111B), whereby the proximal fitting socket overlaps the proximal connection end (213A, 213B), and a proximal connection socket of the proximal connection end (213A, 213B), whereby the proximal connection socket overlaps the proximal fitting attachment end (2111A, 2111B).

3. The liquid cooling system (10) of claim 1 or 2, wherein the distal lap joint is defined by at least one of a distal fitting socket of the distal fitting attachment end (2199A, 2199B), whereby the distal fitting socket overlaps the distal connection end (217A, 217B), and a distal connection socket of the distal connection end, whereby the distal connection socket overlaps the distal fitting attachment end.

4. The liquid cooling system (10) of one of claims 1 to 3, further comprising a proximal filler metal and a distal filler metal, the proximal filler metal defining a proximal capillary space of the proximal lap joint between the proximal connection end (213A, 213B) and the proximal fitting attachment end (2111A, 2111B), the distal filler metal defining a distal capillary space of the distal lap joint between the distal connection end (217A, 217B) and the distal fitting attachment end (2199A, 2199B).

5. The liquid cooling system (10) of one of claims 1 to 4, further comprising a supply manifold (71) and a return manifold (79), the cooling distribution unit (80) fluidly coupled to the supply manifold and the return manifold, the supply manifold further fluidly connected to the at least one direct liquid cooling loop (100, 200, 300) and the return manifold further fluidly connected to the at least one direct liquid cooling loop (100, 200, 300).

6. The liquid cooling system (10) of one of claims 1 to 5, wherein the at least one direct liquid cooling loop (100, 200, 300) or an individual of the at least one direct liquid cooling loop (100, 200, 300), further comprises, at least one cold plate (610), whereby the at least one first integrated circuit component (650) is thermally coupled to the at least one cold plate (610).

7. The liquid cooling system (10) of claim 6, wherein the at least one cold plate (610) comprises an inlet (611) and an outlet (619), whereby the at least one flexible tubing section (210A, 210C) is fluidly in communication with at least one of the inlet (611) and the outlet (619).

8. The liquid cooling system (10) of claim 7, wherein the at least one flexible tubing section (210A, 210C) comprises two of the at least one flexible tubing section (210A, 210C), whereby the at least one flexible tubing section (210A) is fluidly in communication with the outlet (619) and a second of the at least one flexible tubing section (210C) is fluidly in communication with the inlet (611).

9. The liquid cooling system (10) of one of claims 1 to 8, wherein the at least one cold plate (610, 620) comprises a first and a second cold plate (610, 620) and the at least one first integrated circuit component (650) comprises a first and a second first integrated circuit component, whereby the second first integrated circuit component is thermally coupled to the second cold plate (620).

10. The liquid cooling system (10) of claim 9, wherein the at least one flexible tubing section (210A, 210B, 210C) comprises a first, a second and a third flexible tubing section (210A, 210B, 210C), whereby the first flexible tubing section (210A) is fluidly in communication with the outlet (619) of the first cold plate (610), the second flexible tubing section (210B) is fluidly in communication with an inlet (621) of the second cold plate (620), and the third flexible tubing section (210C) is fluidly in communication with the inlet (611) of the first cold plate (610) and an outlet (629) of the second cold plate (620).

11. The liquid cooling system (10) of one of claims 1 to 10, wherein the at least one proximal fitting (211A, 211B) comprises at least one of a straight rigid tubing section (211B), a bent rigid tubing section, a barb fitting, a fluid connector, a sleeve, a push in adapter, an angled adapter fitting, and a spacer fitting.

12. The liquid cooling system (10) of one of claims 1 to 11, wherein the at least one distal fitting (219A, 219B) comprises at least one of a straight rigid tubing section (211B, 211D), a bent rigid tubing section, a barb fitting, a fluid connector, a sleeve, a push in adapter, an angled adapter fitting, and a spacer fitting.

13. The liquid cooling system (10) of one of claims 1 to 12, wherein the at least one flexible tubing section (210A, 210B, 210C) is made of corrugated stainless steel.
